# EUROPEAN PATENT APPLICATION

(11) **EP 1 508 919 A1**
(43) Date of publication of application: **23.02.2005**
(21) Application number: 03368083.6
(22) Date of filing: 22.08.2003
(51) Int. Cl.: H01L 27/085

(54) **Cascaded transistors in one well**

(71) Applicant: Dialog Semiconductor GmbH, 73230 Kirchheim/Teck-Nabern (DE)
(72) Inventor: Knoedgen, Horst, 80997 Munchen (DE)
(74) Representative: Schuffenecker, Thierry

(57) **Abstract**

A semiconductor device for reducing the chip-area on an integrated circuit required for multiple, cascaded MOS transistors, a method of designing said devices and an exemplary portions of circuits using said devices have been achieved. Said novel semiconductor device comprises multiple MOS transistors sharing one common well, one common bulk and are sharing between adjacent MOS transistors each a doped area used as a drain of one transistor and as a source for the other transistor. The chip-area required for the transistors itself of the invented semiconductor device is significantly smaller than the chip-area of conventional transistors having a single well for each transistor. Said MOS transistors, sharing one common well, could be either PMOS transistors or NMOS transistors. The breakdown voltages of said semiconductor device is significantly higher compared to conventional MOS transistors.

## Description

### Technical field of the Invention

The present invention relates generally to a semiconductor device, and more particularly, to a device wherein multiple field-effect transistors (FET) are sharing one common well and to their application in a circuit.

### Description of the Prior Art

The demand for higher levels of integrated circuits of semiconductor chips and the need for greater density and higher performance in these circuits are growing rapidly.

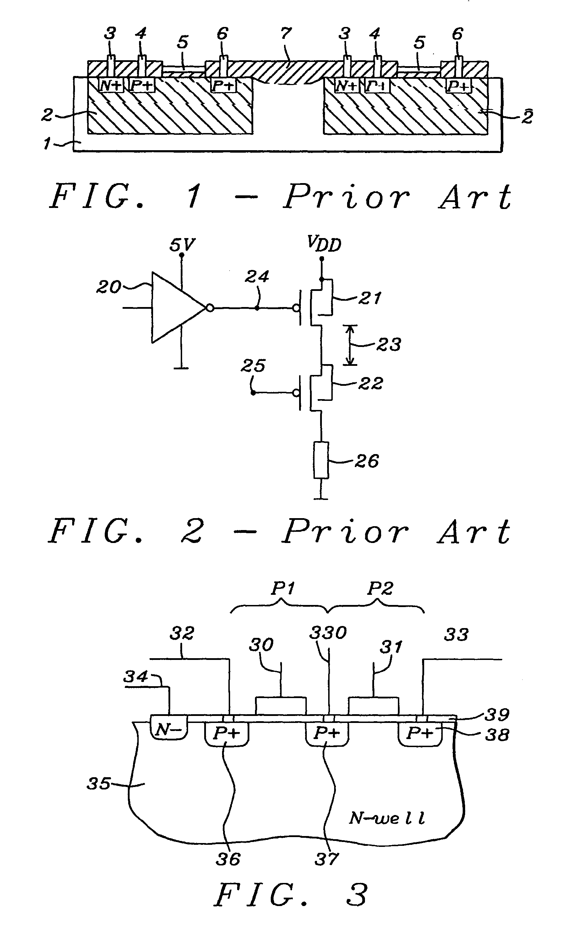

**Fig. 1** prior art shows an overview of two conventional PMOS transistors, being located on a p-substrate **1**, and each having an n-well **2**, a bulk contact **3**, a source **4**, a gate **5**, and a drain **6**. An insulating layer **7** separates both transistors. The distance between both transistors is usually in the order of magnitude of 3µm.

Said n-well has excess electrons. Applying a negative gate voltage drives electrons away and the surface between the source **4** and the drain **6** is inverted by forming an inversion channel between the source and the drain.

It is still a challenge for the engineers to reduce the distance between adjacent transistors and thus to reduce chip area in integrated circuits.

**Fig. 2** prior art shows, as example for an application of cascaded transistors, a portion of a circuit used for a LCD-driver. Said portion of a circuit comprises two cascaded conventional transistors, having one well each, being isolated from each other. Said circuit comprises an inverting amplifier **20**, two PMOS transistors **21** and **22**, a resistor connected between ground and the drain of transistor **22**. Numeral **23** is symbolizing the distance **23** required to isolate the cascaded transistors from each other. It is obvious that said distance **23** required for isolation of both transistors from each other demands precious space on the chip.

It is well known by those skilled in the art that there is a multitude of different applications wherein circuits, having cascaded transistors, are being used.

Reducing the valuable chip-area required for an integrated circuit improves the performance of said circuit and can reduce the manufacturing costs of said circuit. This is a challenge for designers of integrated circuits and of semiconductor devices. There are various solutions known to reduce the chip-area required for integrated circuits focusing on FETs.

U. S. Patent 5,973,377 (to Mizutani) describes that a conventional semiconductor device having a switching function is attended with a problem that in addition to a drawback of a large area occupied by the folded structure of gate electrodes, there are not obtained sufficient effect in association with the minimization in the device size and improvement of the performance. A transmission line is connected to a shared electrode between a drain electrode of a first FET and a source electrode of a second FET. There are disposed a first shared electrode including a drain electrode of the second FET and a source electrode of a third FET and a second shared electrode including drain electrodes of the third and fourth FETs. The second shared electrode is connected to a transmission line. Gate electrodes of the first and fourth FETs and gate electrodes of the second, and third FETs are fabricated to have an identical orientation of the plane of substrate. Consequently, the area occupied by the switching circuit is reduced when compared with the configuration including gate electrodes in the folded contour.

U. S. Patent 5,616,940 (to Kato et al.) discloses a basic cell of gate array having a plurality of p-channel type field effect transistors and a plurality of n-channel type field effect transistors available for electric circuits different in configuration; although gate electrodes are physically separated, a p-channel type field effect transistor and an n-channel type field effect transistor share a p-type source/drain area and an n-type source/drain area with another p-channel type field effect transistor different in channel width from the p-channel type field effect transistor and another n-channel type field effect transistor also different in channel width from the n-channel type field effect transistor so as to selectively use the p-channel type field effect transistors and the n-channel type field effect transistors, and the shared source/drain regions effectively decrease the occupation areas of the field effect transistors.

U. S. Patent 6,287,953 (to Sander et al.) shows a method for fabricating a field effect transistor (FET) in and on a semiconductor substrate with local interconnects to permit the formation of minimal space between gate and the local interconnects by fabricating the source and drain of the FET and the local interconnects prior to forming the gate of the FET.

### Summary of the invention

A principal object of the present invention is to reduce the chip-area on an integrated circuit required for multiple, cascaded MOS transistors

A further object of the present invention is to increase the breakdown voltage of cascaded MOS transistors.

In accordance with the objects of this invention a semiconductor device for reducing the chip-area required for multiple, cascaded MOS transistors has been achieved. Said semiconductor device comprises multiple MOS transistors sharing one common well and a common bulk, wherein between all adjacent transistors a doped area is used as a drain of one transistors and as a source of another transistor.

In accordance with the objects of the invention a method of designing a semiconductor device for reducing the chip-area for multiple, cascaded MOS transistors has been achieved. Said method comprises providing a substrate, external connections, and a common bulk, to share one common well between multiple MOS transistors, and to use a doped region between adjacent MOS transistors as a drain of one transistor and as a source of another adjacent transistor.

In accordance with the objects of the invention a circuit, wherein cascaded transistors are being used, wherein the drains and the sources of adjacent transistors are electrically directly connected and wherein said cascaded transistors are sharing a common well and a common bulk has been achieved.

### Description of the drawings

In the accompanying drawings forming a material part of this description, there is shown:
**Fig. 1** prior art shows a cross section of a conventional NMOS transistor.
**FIG. 2** prior art shows a circuit of an imaging application
**FIG. 3** shows a cross section of a semiconductor device invented
**Fig. 4** illustrates a portion of a circuit using a semiconductor device invented
**Fig. 5** shows a flowchart of a method to design the semiconductor devices invented.

### Description of the preferred embodiments

The preferred embodiments disclose a method how to reduce the chip-area on an IC required for a circuit comprising cascaded transistors, a novel semiconductor device characterized by multiple MOS transistors sharing one common well and an exemplary application of said novel semiconductor device invented in a circuit wherein said circuit is comprising cascaded transistors.

**Fig. 3** shows a preferred embodiment including by way of a non-limiting example of the novel semiconductor device invented. Said device comprises two PMOS-transistors **P1** and **P2**. Both two transistors are sharing a common N-well **35** having a bulk connection **34**. Said transistor **P1** comprises furthermore a gate **30**. The P+ doped region **36** is connected to the source connection **32** of transistor **P1,** another P+ doped region **37** is sharing the function of a drain of transistor **P1** and the function of a source for transistor **P2.** Furthermore the P+ doped region **38** is connected to the drain connection **33** of transistor P2. If required, an optional external connection **330** can be provided to said P+ doped region **37** sharing the function of a drain of transistor **P1** and the function of a source for transistor **P2.** Said transistor **P2** comprises furthermore a gate **31.** An insulating layer **39** is separating the gates **30** and **31** from the N-well 35. Both transistors P1 and P2 work like conventional PMOS transistors. When the voltage at the gate is positive, a current is flowing through a channel between the source and the drain.

It has to be understood that NMOS transistors, sharing a common P-well could be built according to the present inventions in a correspondent, complementary way as described above.

The invented structure is not limited to two transistors sharing a common well and sharing a common drain and source as described above. There could be more than two transistors sharing a common well and sharing source-and-drain regions between adjacent transistors.

Standard processes for building conventional transistors having a single well each can be used to manufacture a device as described above, wherein multiple transistors are sharing one well according to the present invention. It is a matter of layout only. For example, to manufacture the device shown in **Fig. 3** it is required only to put three drain regions and two gates on top of the common drain/source areas. It should be well understood that business-as-usual processes could be used to manufacture a device according to the present invention.

The chip-area required for the transistors itself as part of the invented semiconductor device is significantly smaller than the chip-area of conventional transistors. Furthermore an additional reduction of chip-area is achieved because no well separation is required. In prior art usually a distance of 3 µm is required between two neighbouring wells.

The breakdown voltage between the drain and the well is much higher than the breakdown voltage between the gate and the well. Each transistor is exposed only to the maximum specified voltage between gate and source and drain to source. The higher voltage between the bulk and the gate is isolated by the inversion channel of 5he transistor.

It is obvious for those skilled in art that another embodiment of the invention can be built having NMOS transistors sharing one common P-well and having N-doped regions shared between adjacent NMOS transistors as a drain of a first transistor and a source of a following transistor.

It is well known that circuits comprising cascaded transistors are used in a multitude of very different applications including by way of non-limiting example imaging applications, LCD-drivers, push-pull drivers, etc.

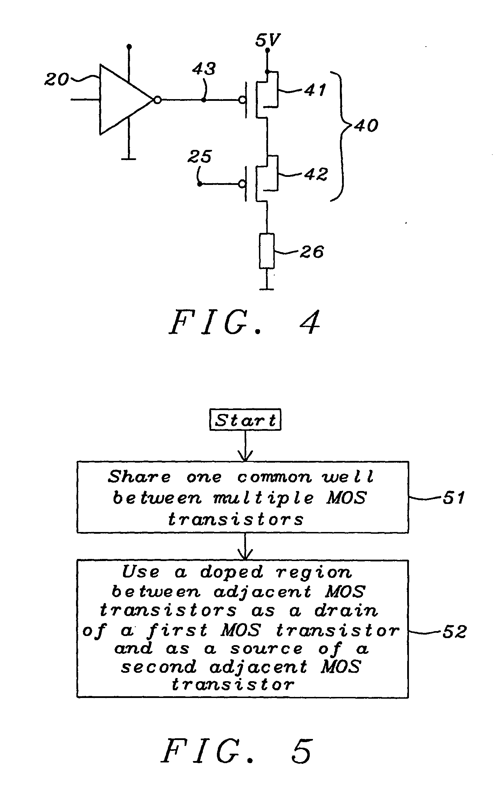

**Fig. 4** shows how the semiconductor devices invented can be used for example in a portion of a circuit comprising cascaded transistors. Said circuit is very similar to the portion of a circuit shown in **Fig. 2** prior art. **Fig. 4** shows an embodiment of the present invention, a semiconductor device **40** comprising two cascaded PMOS transistors **41** and **42** sharing one common well, one common bulk, and one common source/drain region. An inverted amplifier **20** controls the gate **43** of the transistor of the first pair of transistors **40**. The same resistor **26**, as shown **Fig. 1** prior art, is connected to ground. The circuit of **Fig. 4** is thus characterized that there no distance between both transistors **41** and **42** is required any more. Thus the main objective of the invention, namely to reduce the chip area required for a circuit comprising cascaded transistors has been achieved and demonstrated.

**Fig. 5** shows a flowchart of a method to reduce the chip-area required for cascaded MOS transistors as part of an integrated circuit in an integrated circuit. Step **51** shows that a common well is shared between multiple MOS transistors. This could be a N-well for PMOS transistors or a P-well for NMOS transistors. Two or more transistors could share one common well. Step **52** shows that one doped region between the gates of two adjacent transistors is used as a drain of one transistor and as a source of the other transistor. Said doped region can be a p+ region for PMOS transistors or an n- region for NMOS transistors. In case those three transistors are sharing one common well a common source/drain region will be required between the first and the second transistor and another common source/drain region will be required between the second and the third transistor. Said common regions are required between all transistors sharing a common well.

While the invention has been particularly shown and described with reference to the preferred embodiments thereof, it will be understood by those skilled in the art that various changes in form and details may be made without departing from the spirit and scope of the invention.

## Claims

1. A semiconductor device for reducing the chip-area required for multiple, cascaded MOS transistors, comprising multiple MOS transistors sharing one common well and a common bulk, wherein between all adjacent transistors a doped area is used as a drain of one transistors and as a source of another transistor.

2. The semiconductor device of claim 1 wherein said MOS transistors are PMOS transistors and wherein said common well is a N-well.

3. The semiconductor device of claim 2 wherein two PMOS transistors are sharing a common N-well and a common bulk, wherein external connections are provided for said common bulk, for the source of a first PMOS transistor, and for the drain of the second PMOS transistor, and wherein a p-doped region between both said PMOS transistors is forming a drain for said first PMOS transistor and a source for the second, adjacent PMOS transistor.

4. The semiconductor device of claim 3 wherein an external connection is additionally provided for said p-doped region forming a drain for said first PMOS transistor and a source for said second PMOS transistor.

5. The semiconductor device of claim 2 wherein more than two PMOS transistors are sharing a common N-well and a common bulk, wherein external connections are provided for said common bulk, for the source of a first PMOS transistor, for the drain of a last PMOS transistor, and for the gates of each transistor of said semiconductor device.

6. The semiconductor device of claim 5 wherein an additional optional external connection is provided for one of said p-doped region forming a drain of a first PMOS transistor and a source for an adjacent PMOS transistor.

7. The semiconductor device of claim 5 wherein more than one additional optional external connection are provided for said p-doped regions each forming a drain of a first PMOS transistor and a source for an adjacent second PMOS transistor.

8. The semiconductor device of claim 1 wherein said MOS transistors are NMOS transistors and wherein said common well is a P-well.

9. The semiconductor device of claim 8 wherein two NMOS transistors are sharing a common P-well and a common bulk, wherein external connections are provided for said common bulk, for the source of a first NMOS transistor, and for the drain of the second NMOS transistor, and wherein a n-doped region between both said NMOS transistors is forming a drain for said first NMOS transistor and a source for the second adjacent NMOS transistor.

10. The semiconductor device of claim 9 wherein an external connection is additionally provided for said n-doped region forming a drain for said first NMOS transistor and a source for said second NMOS transistor.

11. The semiconductor device of claim 8 wherein more than two NMOS transistors are sharing a common P-well and a common bulk, wherein external connections are provided for said common bulk, for the source of a first NMOS transistor, for the drain of a last NMOS transistor, and for the gates of each transistor of said semiconductor device.

12. The semiconductor device of claim 11 wherein an additional optional external connection is provided for one of said n-doped region forming a drain of a first NMOS transistor and a source for an adjacent NMOS transistor.

13. The semiconductor device of claim 11 wherein more than one additional optional external connection are provided for said n-doped regions each forming a drain of a first NMOS transistor and a source for an adjacent second NMOS transistor.

14. A method of designing a semiconductor device for reducing the chip-area for multiple, cascaded MOS transistors comprising:
providing a substrate, external connections, and a common bulk;
share one common well between multiple MOS transistors; and
use a doped region between adjacent MOS transistors as a drain of one transistor and as a source of another adjacent transistor.

15. The method of claim 14 wherein said multiple MOS transistors are PMOS transistors.

16. The method of claim 15 wherein two PMOS transistors are sharing a common N-well and a common bulk, wherein external connections are provided for said common bulk, for the source of a first PMOS transistor, and for the drain of the second PMOS transistor, and wherein a p-doped region between both said PMOS transistors is forming a drain for said first PMOS transistor and a source for the second, adjacent PMOS transistor.

17. The method of claim 16 wherein an external connection is additionally provided for said p-doped region forming a drain for said first PMOS transistor and a source for said second PMOS transistor.

18. The method of claim 15 wherein more than two PMOS transistors are sharing a common N-well and a common bulk, wherein external connections are provided for said common bulk, for the source of a first PMOS transistor, for the drain of a last PMOS transistor, and for the gates of each transistor of said semiconductor device.

19. The method of claim 18 wherein an additional optional external connection is provided for one of said p-doped region forming a drain of a first PMOS transistor and a source for an adjacent second PMOS transistor.

20. The method of claim 18 wherein more than one additional optional external connections are provided for said p-doped regions each forming a drain of a first PMOS transistor and a source for an adjacent second PMOS transistor.

21. The method of claim 14 wherein said MOS transistors are NMOS transistors and wherein said common well is a P-well.

22. The method of claim 21 wherein two NMOS transistors are sharing a common P-well and a common bulk, wherein external connections are provided for said common bulk, for the source of a first NMOS transistor, and for the drain of the second NMOS transistor, and wherein a n-doped region between both said NMOS transistors is forming a drain for said first NMOS transistor and a source for the second adjacent NMOS transistor.

23. The method of claim 22 wherein an external connection is additionally provided for said n-doped region forming a drain for said first NMOS transistor and a source for said second NMOS transistor.

24. The method of claim 21 wherein more than two NMOS transistors are sharing a common P-well and a common bulk, wherein external connections are provided for said common bulk, for the source of a first NMOS transistor, for the drain of a last NMOS transistor, and for the gates of each transistor of said semiconductor device.

25. The method of claim 24 wherein an additional optional external connection is provided for one of said n-doped region forming a drain of a first NMOS transistor and a source for an adjacent NMOS transistor.

26. The method of claim 24 more than one additional optional external connections are provided for said n-doped regions each forming a drain of a first NMOS transistor and a source for an adjacent second NMOS transistor.

27. A circuit, wherein cascaded transistors are being used, wherein the drains and the sources of adjacent transistors are electrically directly connected and wherein said cascaded transistors are sharing a common well and a common bulk.

28. The circuit of claim 27 wherein said cascaded MOS transistors are PMOS transistors.

29. The circuit of claim 28 wherein two PMOS transistors are sharing a common N-well and a common bulk, wherein external connections are provided for said common bulk, for the source of a first PMOS transistor, and for the drain of the second PMOS transistor, and wherein a p-doped region between both said PMOS transistors is forming a drain for said first PMOS transistor and a source for the second, adjacent PMOS transistor.

30. The circuit of claim 29 wherein an external connection is additionally provided for said p-doped region forming a drain for said first PMOS transistor and a source for said second PMOS transistor.

31. The circuit of claim 28 wherein more than two PMOS transistors are sharing a common N-well and a common bulk, wherein external connections are provided for said common bulk, for the source of a first PMOS transistor, for the drain of a last PMOS transistor, and for the gates of each transistor of said semiconductor device.

32. The circuit of claim 31 wherein an additional optional external connection is provided for one of said p-doped region forming a drain of a first PMOS transistor and a source for an adjacent PMOS transistor.

33. The circuit of claim 31 wherein more than one additional optional external connections are provided for said p-doped regions each forming a drain of a first PMOS transistor and a source for an adjacent second PMOS transistor.

34. The circuit of claim 27 wherein said MOS transistors are NMOS transistors and wherein said common well is a P-well.

35. The circuit of claim 34 wherein two NMOS transistors are sharing a common P-well and a common bulk, wherein external connections are provided for said common bulk, for the source of a first NMOS transistor, and for the drain of the second NMOS transistor, and wherein a n-doped region between both said NMOS transistors is forming a drain for said first NMOS transistor and a source for the second adjacent NMOS transistor.

36. The circuit of claim 35 wherein an external connection is additionally provided for said n-doped region forming a drain for said first NMOS transistor and a source for said second NMOS transistor.

37. The circuit of claim 34 wherein more than two NMOS transistors are sharing a common P-well and a common bulk, wherein external connections are provided for said common bulk, for the source of a first NMOS transistor, for the drain of a last NMOS transistor, and for the gates of each transistor of said semiconductor device.

38. The circuit of claim 37 wherein an additional optional external connection is provided for one of said n-doped region forming a drain of a first NMOS transistor and a source for an adjacent NMOS transistor.

39. The circuit of claim 37 more than one additional optional external connections are provided for said n-doped regions each forming a drain of a first NMOS transistor and a source for an adjacent second NMOS transistor.

40. The circuit of claim 27 wherein said cascaded transistors are being used for an imaging application.
